# EUROPÄISCHE PATENTSCHRIFT

(11) **EP 0 352 824 B1**
(45) Veröffentlichungstag und Bekanntmachung des Hinweises auf die Patenterteilung: **03.11.1993**
(21) Anmeldenummer: 89117595.2
(22) Anmeldetag: 11.08.1986
(51) Int. Cl.: G01R 33/34

(54) **Lokalspulenanordnung für die Untersuchung mit Hilfe der kernmagnetischen Resonanz**
Local coil arrangement for NMR examination
Système localisé de bobines pour examen par RMN

(30) Priorität: 18.11.1985 DE 3540872
(43) Veröffentlichungstag der Anmeldung: 31.01.1990
(62) Teilanmeldung aus: 86111082.3
(73) Patentinhaber: SIEMENS AKTIENGESELLSCHAFT, 80333 München (DE)
(72) Erfinder: Zabel, Hans-Joachim, D-6900 Heidelberg (DE); Bader, Reiner, Dr., D-6900 Heidelberg (DE); Lorenz, Walter J., Prof. Dr., D-6900 Heidelberg (DE)

(56) Entgegenhaltungen:
- WO-A-84/00214
- JOURNAL OF MAGNETIC RESONANCE, Band 60, Oktober 1984, Seiten 473-478, Academic Press, Inc.; M.R. BENDALL et al.: "Active detune switch for complete sensitive-volume localization in in Vivo spectroscopy using multiple rf coils and depth pulses"
- MAGNETIC RESONANCE, Band 2, 1985, Seiten 169-175, Academic Press, Inc.; T.C. NG et al.: "Shielded solenoidal probe for in Vivo NMR studies of solid tumors"
- JOURNAL OF MAGNETIC RESONANCE, Band 64, 2. September 1985, Seiten 255-270, Academic Press, Inc.; G.H. GLOVER et al.: "Comparison of linear and circular polarization for magnetic resonance imaging"
- JOURNAL OF MAGNETIC RESONANCE 54 (1983) 324-327, C.N. Chen et al. : "Quadrature Detection Coils - A Further V2 Improvement in Sensitivity"

## Beschreibung

Die Erfindung betrifft eine Lokalspulenanordnung mit mindestens zwei Lokalspulen für spektroskopische oder bildgebende Untersuchungen eines Objektes mit Hilfe der kernmagnetischen Resonanz. Das Untersuchungsobjekt befindet sich dabei in einem homogenen magnetischen Grundfeld einer MR-Anlage. Die Lokalspule wird in der Nähe des zu untersuchenden Bereiches positioniert und kann mit Hilfe eines Hochfrequenzpulses über das magnetische Wechselfeld die Kernspins des Untersuchungsobjektes anregen. Danach wird das von den angeregten Kernspins ausgesandte Kernresonanzsignal von der Lokalspule aufgenommen und in der MR-Anlage abgespeichert.

Anwendungen von Lokalspulen in der Phosphorspektroskopie sind z.B. in den Artikeln "Journal of Magnetic Resonance" 60, Seiten 268 bis 279 (1984) und "Journal of Magnetic Resonance" 55, Seiten 164 bis 169 (1983) beschrieben worden. Eine durch ein Koaxialleiterstück geformte Antenne ist aus DE-C-912 583 und JP-A-5 627 509 bekannt.

Aus der WO 84/00214 ist die Verwendung einer Parallelanordnung, insbesondere einer Helmholtz-Anordnung von ringförmigen Antennen zur Erzielung eines homogenen RF-Feldes in der Kernspinspektroskopie bekannt. Die einzelnen Antennen sind dabei als ringförmige Wellenleiter ausgelegt.

Aus "Journal of Magnetic Resonance", Band 54, 1983, C.-N. Chen et al. "Quadrature Detection Coils - A Further √2̅ Improvement in Sensitivity", Seiten 324-327 ist eine Anordnung von ringförmigen Antennen für die Kernspinresonanz bekannt, die zur Erzeugung eines zirkular polarisierten Hochfrequenzfeldes dient.

In der Literaturstelle "Journal of Magnetic Resonance", Band 64, September 1985, G.H. Glover et al. "Comparison of Linear and Circular Polarization for Magnetic Resonance Imaging", Seiten 255-270 wird auf die Vorteile der zirkularen Polarisation insbesondere im Hinblick auf das Signal-Rausch-Verhältnis und die Verringerung der erforderlichen Hochfrequenzleistung hingewiesen.

Mit Lokalspulen für die Anregung und den Signalempfang werden durch die Beschränkung auf kleinere Untersuchungsbereiche eine höhere Bildqualität (Signal-Rausch-Verhältnis) und damit eine höhere Detailerkennbarkeit erreicht. Diese Spulen können dem jeweiligen Untersuchungsbereich geometrisch angepaßt werden.

Lokalspulen werden meistens im Zusammenwirken mit abstimmbaren Schwingkreisen benutzt. Ein Nachteil dieser Schaltung ist die Empfindlichkeit ihrer Abstimmung auf elektrische Störstrahlungen von außen oder auch die Bewegung des Untersuchungsobjektes, die zu Phasenfehlern führt. Ebenso nachteilig sind die aufwendige Herstellung der elektrischen Anpaßeinheit, die Unflexibilität in der Anwendung des komplexen Systems, die Unhandlichkeit für die Anwendung am menschlichen Körper sowie die daraus und aus dem Abstimmvorgang resultierende lange Meßvorbereitungszeit.

Der Erfindung liegt die Aufgabe zugrunde, eine einfach aufgebaute, handliche Lokalspulenanordnung zu schaffen, welche leicht anpaßbar und störstrahlungssicher ist und die aufgrund einer guten Homogenität eine Signalerfassung über einen größeren Volumenbereich ermöglicht.

Die Aufgabe wird erfindungsgemäß durch die Merkmale des Anspruchs 1 und in einer alternativen Ausführungsform durch die Merkmale des Anspruchs 2 gelöst.

Die Ausbildung der einzelnen Lokalspulen wirkt als Rahmenantenne, die zur Vermeidung von Störungen mit einer an bevorzugter Stelle unterbrochenen koaxialen Abschirmung versehen ist. Das Koaxialleiterstück kann, wenn es flexibel ausgeführt wird, zu einer beliebig geformten Schleife gebogen werden. An einem Ende des Koaxialleiterstückes werden sowohl der Innenleiter als auch die Mantelabschirmung mit der Mantelabschirmung des anderen Endes des Koaxialleiterstückes elektrisch leitend verbunden. Dort ist auch der elektrische Einspeisungspunkt über ein koaxiales Einspeisungskabel vorgesehen.

Die Schlitzbreite der Unterbrechung der Mantelabschirmung sollte etwa dem Abstand des Innenleiters zur Mantelabschirmung entsprechen. Die Anpassung der Rahmenantenne an den Eingang des Meßverstärkers geschieht durch λ/2 Transformation über die koaxiale Einspeisungsleitung. In einer bevorzugten Ausführungsform kann das schleifenförmige Koaxialleiterstück durch das Endstück einer koaxialen Einspeisungsleitung gebildet werden. Die Anpassung kann in diesem Fall z.B. dadurch erreicht werden, daß die Gesamtlänge der Leitung mit n λ/2 gewählt wird. Diese einfache Art der Antennenausführung und der Antennenankopplung ist sehr handlich bei der Anwendung am Patienten und vermeidet die approximative, kapazitive Abstimmung. Eine verbesserte Bildqualität und räumliche Auflösung wird insbesondere im Frequenzbereich von Hochfeld-Kernspintomographen (größer 1 Tesla) erreicht und bleibt durch die Faradaysche Wirkung der Mantelabschirmung auch bei ungenügender Raumabschirmung von äußeren elektrischen Störstrahlungen unbeeinflußt. In dem von den Lokalspulen eingeschlossenen Untersuchungsraum ist die HF-Signal-Empfindlichkeitsverteilung verhältnismäßig homogen.

Vorteilhafte Ausgestaltungen der Erfindung sind in den Unteransprüchen angegeben.

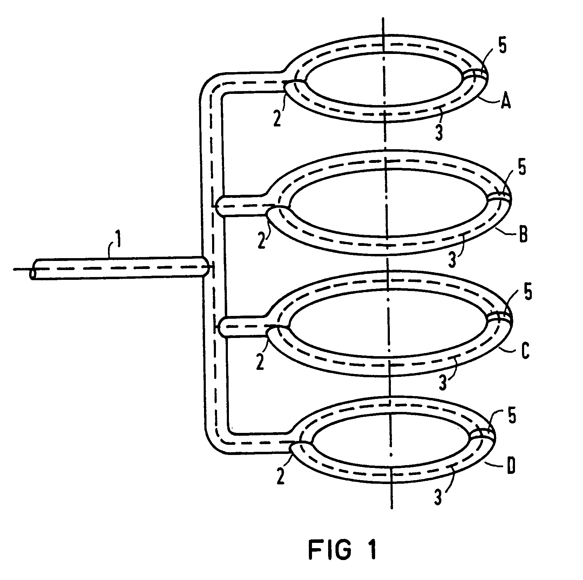

Die Erfindung ist nachfolgend anhand von Ausführungsbeispielen nach den Figuren 1 bis 4 näher erläutert.

Fig. 1 zeigt ein erstes Ausführungsbeispiel, bei dem vier Lokalspulen A - D räumlich parallel in Form einer Helmholtz-Anordnung vorgesehen sind. Die einzelnen Lokalspulen A - D sind parallel an eine gemeinsame Einspeiseleitung 1 angeschlossen, wobei die jeweiligen Leitungslängen symmetrisch zur Einspeiseleitung 1 sein müssen. Mit dieser Helmholtz-Anordnung wird die HF-Anregung und die Signalerfassung aufgrund der verbesserten Homogenität über einen größeren Volumenbereich möglich.

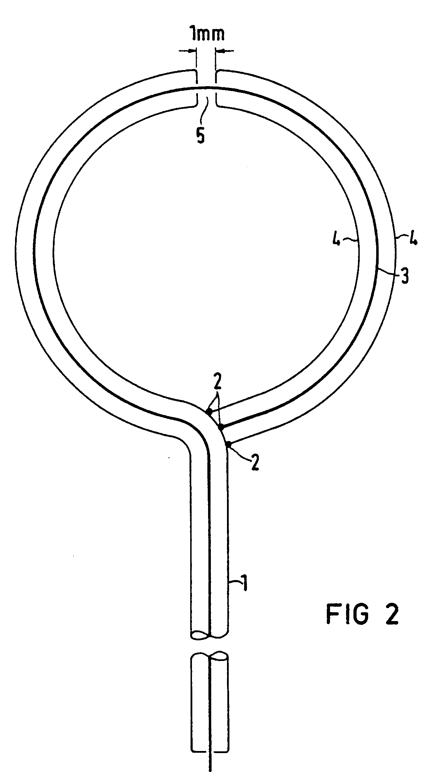

Der Aufbau jeder einzelnen Lokalspule A - D ist in Fig. 2 im Detail dargestellt. Jede Lokalspule A - D besteht aus einem Koaxialleiter 1, der zu einer kreisförmigen Schlaufe gebogen ist und am Ende 2 jeder Schlaufe sind sowohl der Innenleiter 3 als auch die Mantelabschirmung 4 mit der Mantelabschirmung am Anfangspunkt 2 der Schleife elektrisch verbunden. An einem dem Anfangspunkt 2 der Schleife gegenüberliegenden Punkt 5 weist die Abschirmung 4 eine Unterbrechung auf (ca. 1 mm).

Die geringe Anfälligkeit gegen kapazitive Verstimmung der als Koaxialleiter aufgebauten Lokalspule ermöglicht es, auch komplexere Antennensysteme mit mehreren Lokalspulen ohne Probleme mit der gegenseitigen Verstimmung vorzusehen. Damit wird eine flexible Anpassung an das Untersuchungsobjekt mit einer Erhöhung des Füllfaktors möglich.

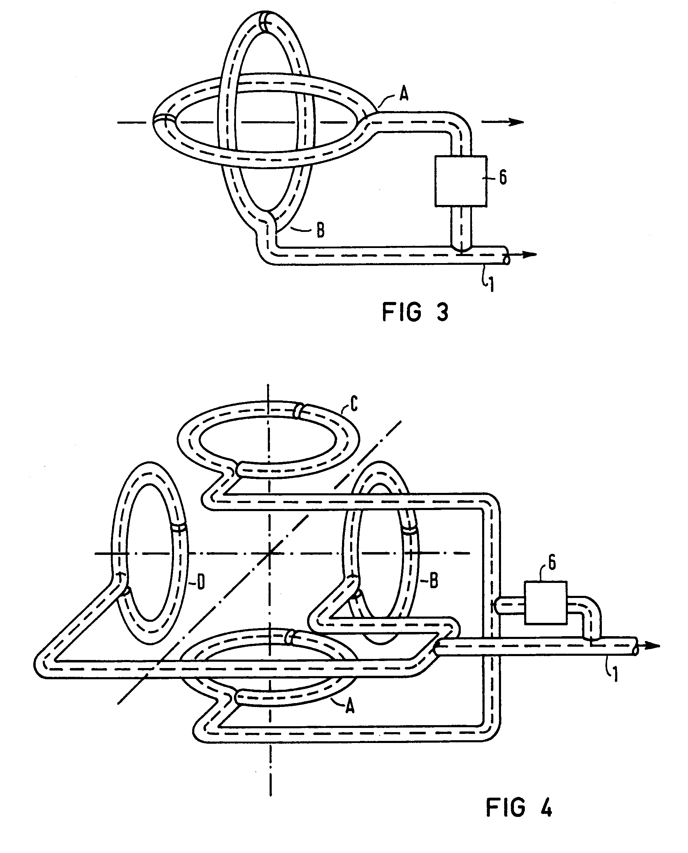

Die in Fig. 1 dargestellte Ausführungsform arbeitet mit linear polarisierten HF-Feldern. Mit der erfindungsgemäßen Ausgestaltung der Lokalspulen sind jedoch auch Antennenanordnungen mit zirkular polarisierten HF-Feldern möglich, die bei geringerer Sendeleistung noch homogenere HF-Anregung als lineare Felder erzeugen. Ein erstes Ausführungsbeispiel für eine Anordnung mit zirkular polarisiertem HF-Feld ist in Fig. 3 dargestellt. Dabei sind zwei Lokalspulen A, B räumlich senkrecht zueinander angeordnet, so daß sie einen Untersuchungsraum einschließen. Die Lokalspule A wird an die Einspeiseleitung 1 über einen 90°-Phasenschieber 6 angeschlossen, so daß im Untersuchungsraum ein zirkular polarisiertes Feld entsteht und erfaßt werden kann.

Ein weiteres Ausführungsbeispiel für zirkular polarisierte HF-Felder, das in einem größeren Volumenbereich eine homogene HF-Anregung ermöglicht, ist in Fig. 4 dargestellt. Dabei sind zwei Spulenpaare A, C und B, D vorgesehen, deren Achsen senkrecht zueinander stehen. Die beiden Spulen A, C und B, D jedes Spulenpaares sind räumlich parallel zueinander angeordnet und elektrisch parallel geschaltet. Während das Spulenpaar B, D direkt an die Einspeiseleitung 1 angeschlossen ist, erfolgt die Einspeisung des Spulenpaares A, C über die Einspeiseleitung 1 und einen 90°-Phasenschieber 6. Die Oberflächenspulen A - D schließen einen Untersuchungsraum ein, der mit einem zirkular polarisierten HF-Feld beaufschlagbar und erfaßbar ist.

## Patentansprüche

1. Lokalspulenanordnung mit mindestens zwei einen Untersuchungsraum einschließenden Lokalspulen (A-D) für die spektroskopische oder bildgebende Untersuchung eines Objektes mit Hilfe der kernmagnetischen Resonanz, wobei die Lokalspulen (A-D) mit ihren Spulenebenen räumlich parallel angeordnet und parallel an eine Einspeiseleitung (1) angeschlossen sind, dadurch gekennzeichnet, daß jede Lokalspule (A-D) durch ein zu einer Schleife geformtes Koaxialleiterstück gebildet wird, dessen Mantelabschirmung (4) an einem dem Anfangspunkt der Schleife gegenüberliegenden Punkt (5) eine Unterbrechung aufweist, wobei an einem Ende (2) des Koaxialleiterstückes sowohl der Innenleiter (3) als auch die Mantelabschirmung (4) mit der Mantelabschirmung des anderen Endes des Koaxialleiterstückes elektrisch verbunden sind, und wobei jede Lokalspule mit Hilfe einer λ/2-Transformation über die Einspeiseleitung angepaßt ist.

2. Lokalspulenanordnung mit mindestens zwei einen Untersuchungsraum einschließenden Lokalspulen (A,B) für die spektroskopische oder bildgebende Untersuchung eines Objektes mit Hilfe der kernmagnetischen Resonanz, wobei zwei Lokalspulen (A,B) mit ihren Spulenebenen senkrecht zueinander angeordnet sind und die Lokalspulen (A,B) über einen 90°-Phasenschieber zur Erzeugung eines zirkular polarisierten HF-Feldes verbunden sind, dadurch gekennzeichnet, daß jede Lokalspule (A,B) durch ein zu einer Schleife geformtes Koaxialleiterstück gebildet wird, dessen Mantelabschirmung (4) an einem dem Anfangspunkt der Schleife gegenüberliegenden Punkt (5) eine Unterbrechung aufweist, wobei an einem Ende (2) des Koaxialleiterstückes sowohl der Innenleiter (3) als auch die Mantelabschirmung (4) mit der Mantelabschirmung des anderen Endes des Koaxialleiterstückes elektrisch verbunden sind, und wobei jede Lokalspule (A,B) mit Hilfe einer λ/2-Transformation über eine Einspeiseleitung mit ihren Spulenebenen angepaßt ist.

3. Lokalspule nach Anspruch 1, **dadurch gekennzeichnet,** daß jedes schleifenförmige Koaxialleiterstück durch das Endstück einer koaxialen Einspeiseleitung (1) gebildet wird.

4. Lokalspule nach einem der Ansprüche 1 bis 3, **dadurch gekennzeichnet,** daß jedes schleifenförmige Koaxialleiterstück flexibel ist und entsprechend den räumlichen Erfordernissen bei der Untersuchung des Objektes gebogen werden kann.

5. Lokalspulenanordnung nach Anspruch 1, **dadurch gekennzeichnet,** daß die Lokalspulen (A-D) in einer Helmholtz-Anordnung angeordnet sind.

6. Lokalspulenanordnung nach Anspruch 2, **dadurch gekennzeichnet,** daß jeder Lokalspule (A,B) räumlich parallel je eine zweite Lokalspule (C,D) zugeordnet ist, so daß die Anordnung mit insgesamt vier Lokalspulen (A-D) einen Untersuchungsraum einschließt und daß die räumlich parallelen Lokalspulen (A,C;B,D) jeweils auch elektrisch parallel geschaltet sind.

## Claims

1. Local coil arrangement with at least two local coils (A-D), enclosing an examination area, for the spectroscopic or image-producing examination of an object with the aid of nuclear-magnetic resonance, wherein the local coils (A-D) are arranged with their coil planes spatially parallel and are attached in parallel to a feed line (1), characterized in that each local coil (A-D) is formed by a coaxial conductor element formed into a loop, the sleeve screening (4) of which has an opening at a point (5) opposite to the starting point of the loop, wherein at one end (2) of the coaxial conductor element both the inner conductor (3) and the sleeve screening (4) are electrically connected to the sleeve screening of the other end of the coaxial conductor element, and wherein each local coil is adapted with the aid of a λ/2-transformation by way of the feed line.

2. Local coil arrangement with at least two local coils (A,B), enclosing an examination area, for the spectroscopic or image-producing examination of an object with the aid of nuclear-magnetic resonance, wherein two local coils (A,B) are arranged with their coil planes perpendicular to one another and the local coils (A,B) are connected by way of a 90° phase shifter for the generation of a HF-field polarized in a circular manner, characterized in that each local coil (A,B) is formed by a coaxial conductor element formed into a loop, the sleeve screening (4) of which has an opening at a point (5) opposite the starting point of the loop, wherein at an end (2) of the coaxial conductor element both the inner conductor (3) and the sleeve screening (4) are electrically connected to the sleeve screening of the other end of the coaxial conductor element, and wherein each local coil (A,B) is adapted with the aid of a λ/2-transformation by way of a feed line with its coil planes.

3. Local coil according to claim 1, characterized in that each loop-shaped coaxial conductor element is formed by the end piece of a coaxial feed line (1).

4. Local coil according to one of claims 1 to 3, characterized in that each loop-shaped coaxial conductor element is flexible and can be bent according to the spatial requirements with the examination of the object.

5. Local coil arrangement according to claim 1, characterized in that the local coils (A-D) are arranged in a Helmholtz arrangement.

6. Local coil arrangement according to claim 2, characterized in that with each local coil (A,B) there is associated spatially parallel in each case a second local coil (C,D), so that the arrangement with a total of four local coils (A-D) encloses an examination area and in that the spatially parallel local coils (A,C;B,D) are in each case also electrically connected in parallel.

## Revendications

1. Dispositif à bobines locales comportant au moins deux bobines locales (A-D), qui enserrent un espace d'examen, pour l'examen spectroscopique ou pour l'imagerie d'un objet à l'aide de la résonance magnétique nucléaire, dans lequel les plans des bobines locales (A-D) sont disposés en parallèle dans l'espace et les bobines sont raccordées en parallèle à un conducteur d'alimentation (1), caractérisé par le fait que chaque bobine locale (A-D) est formée par un élément de câble coaxial réalisé en forme de boucle, dont le blindage enveloppe (4) présente une interruption en un point (5) situé à l'opposé du point de départ de la boucle, aussi bien le conducteur intérieur (3) que le blindage enveloppe (4) étant raccordés électriquement, à une extrémité (2) de l'élément de câble coaxial, au blindage enveloppe de l'autre extrémité de l'élément de câble coaxial, chaque bobine locale étant adaptée à l'aide d'une transformation λ/2, sur l'étendue du conducteur d'alimentation.

2. Dispositif à bobines locales comportant au moins deux bobines locales (A-D), qui enserrent un espace d'examen, pour l'examen spectroscopique ou pour l'imagerie d'un objet à l'aide de la résonance magnétique nucléaire, dans lequel les plans des bobines locales (A-D) sont disposés en parallèle dans l'espace et les bobines sont raccordées en parallèle à un conducteur d'alimentation (1), dans lequel les plans de deux bobines locales (A,B) sont perpendiculaires entre eux, et des bobines locales (A,B) sont reliées par l'intermédiaire d'un déphaseur réalisant un déphasage de 90° pour produire un champ HF à polarisation circulaire, caractérisé par le fait que chaque bobine locale (A,B) est formée par un élément de câble coaxial en forme de boucle, dont le blindage enveloppe (4) présente une interruption en un point (5) situé à l'opposé du point de départ de la boucle, aussi bien le conducteur intérieur (3) que le blindage enveloppe (4) étant raccordés électriquement, à une extrémité (2) de l'élément de câble coaxial, au blindage enveloppe de l'autre extrémité de l'élément de câble coaxial, chaque bobine locale étant adaptée à l'aide d'une transformation 1/2, par l'intermédiaire d'un conducteur d'alimentation (1).

3. Bobine locale suivant la revendication 1, caractérisée par le fait que chaque élément de câble coaxial en forme de bouche est formé par l'élément d'extrémité d'une ligne d'alimentation coaxiale (1).

4. Bobine locale suivant l'une des revendications 1 à 3, caractérisée par le fait que chaque élément de câble coaxial en bouche est flexible et peut être replié en fonction des exigences du point de vue spatial, lors de l'examen de l'objet.

5. Bobine locale suivant la revendication 1, caractérisée par le fait que les bobines locales (A-D) sont agencées dans un dispositif de Helmholtz.

6. Bobine locale suivant la revendication 2, caractérisée par le fait que respectivement une seconde bobine locale (C,D) est associée à chaque bobine locale (A,B), en étant parallèle à cette dernière dans l'espace, de sorte que le dispositif comportant au total quatre bobines locales (A-D) enserre un espace d'examen et que les bobines locales (A,C;B,D), qui sont parallèles dans l'espace, sont également branchées respectivement en parallèle du point de vue électrique.
